# DEMANDE DE BREVET EUROPEEN

(11) **EP 3 131 116 A1**
(43) Date de publication de la demande: **15.02.2017**
(21) Numéro de dépôt: 16181484.3
(22) Date de dépôt: 27.07.2016
(51) Int. Cl.: H01L 21/762, H01L 27/06, H01L 21/18

(54) **PROCÉDÉ DE RÉALISATION D'UN DISPOSITIF ÉLECTRONIQUE**

(30) Priorité: 31.07.2015 FR 1557436
(71) Demandeur: COMMISSARIAT A L'ENERGIE ATOMIQUE ET AUX ENERGIES ALTERNATIVES, 75015 Paris (FR)
(72) Inventeur: FOURNEL, Frank, 38190 VILLARD-BONNOT (FR); DEGUET, Chrystel, 38000 GRENOBLE (FR)
(74) Mandataire: Decobert, Jean-Pascal

(57) **Abrégé**

L'invention concerne un procédé de réalisation d'un dispositif électronique comprenant en empilement au moins une première structure (15) et une deuxième structure (16), les structures étant obtenues à partir d'un premier substrat (3) et d'un deuxième substrat (9). Des marques sont obtenues à partir d'un motif fait sur l'un des substrats. En outre, les mêmes supports sont utilisés durant la phase de collage pour la préparation des marques et pour la phase de collage pour l'assemblage des structures. Les alignements sont donc meilleurs.

## Description

### DOMAINE DE L'INVENTION

L'invention est relative à un procédé de réalisation d'un dispositif électronique comprenant en empilement au moins une première structure et une deuxième structure.

Un intérêt de l'invention est de permettre un bon alignement des structures empilées. Elle trouve particulièrement son application dans la fabrication de dispositifs microélectroniques tridimensionnels, pour lesquels les composants ne sont plus ou plus seulement situés dans un plan unique d'un substrat, mais sont aussi produits en superposition, grâce à des couches de substrats superposés incorporant des composants. Plus spécifiquement, la présente invention s'applique par exemple à la réalisation d'imageurs rétro-éclairés et à la réalisation de l'empilement de deux substrats CMOS.

### ETAT DE LA TECHNIQUE

Les dispositifs tridimensionnels requièrent des assemblages de structures (typiquement des substrats ayant subi des traitements). La bonne mise en correspondance de ces structures est un enjeu fondamental pour la fiabilité du dispositif final et pour réduire la taille des composants, tels des contacts électriques à la surface de deux structures et qu'ils convient de faire coopérer.

Les procédés d'assemblage connus emploient des marquages servant par ailleurs de repères dans beaucoup d'étapes de traitements microélectroniques.

De façon générale, sur un substrat qui présente des motifs, il existe deux grandes familles de marques:
- Les marques d'alignement primaires qui sont souvent peu nombreuses et situées de part et d'autre des substrats. Ces marques d'alignement primaires permettent, sur un même substrat, de repérer les marques d'alignement secondaires
- Les marques d'alignement secondaires sont en général beaucoup plus nombreuses et se répètent sur la surface du substrat autant de fois qu'un groupe de motifs doit être répété en plusieurs zones unitaires. Ces marques d'alignement secondaires permettent de créer les motifs en assurant leur positionnement très précis au sein d'une même zone unitaire. Il y a donc beaucoup plus de motifs que de marques d'alignement secondaires. Les motifs sont créés en les positionnant par rapport aux marques secondaires. Ils peuvent s'étendre suivant l'épaisseur du substrat, et par exemple être constitués de couche de matériaux diélectriques ou semi-conducteurs.

De façon générale, quand on reporte un premier substrat sur un deuxième substrat et que l'on cherche à aligner des motifs de chaque zone unitaire des deux substrats, les possibilités de décalage sont les suivantes.

Un premier désalignement est dû à la précision d'alignement du report d'un substrat sur l'autre. Ce désalignement, global car il concerne tous les motifs, se retrouve notamment en mesurant le désalignement entre les marques primaires du premier substrat vis-à-vis des marques primaires du deuxième substrat.

Un deuxième désalignement est celui des marques d'alignement secondaires vis-à-vis des marques primaires au sein d'un même substrat lors de leur réalisation. Ce désalignement est en fait un mauvais positionnement des marques secondaires par rapport aux marques primaires. Il peut être de l'ordre de plus ou moins 50nm par exemple. Mais ce mauvais positionnement va impliquer un mauvais positionnement global des motifs d'une zone unitaire par rapport aux marques d'alignement primaires. Ce défaut peut se produire même si la première source de désalignement, mentionnée au paragraphe précédent, est faible ou inexistante. Les motifs du premier substrat ne seront pas correctement alignés par rapport aux motifs du deuxième substrat. Comme ce désalignement peut survenir de façon aléatoire et présente une amplitude aléatoire pour chaque zone unitaire, il est donc très difficile, voire impossible, de le corriger lors de l'alignement global des substrats pour le report.

Une troisième source de désalignement est due à la déformation de plaque des substrats lors de l'opération de report. En particulier, un collage direct provoque des distorsions. Ces distorsions peuvent modifier le placement relatif des marques secondaires car celles-ci sont justement situées à l'interface de collage.

Ces déplacements des marques d'alignement peuvent être suffisamment importants pour empêcher la réalisation de procédés technologiques ultérieurs. Par exemple, après un collage et un amincissement qui permet d'avoir accès aux marques d'alignement d'un des substrats notamment pour des technologies CMOS, la distorsion peut empêcher les machines de lithographie de retrouver les marques secondaires d'alignement empêchant ainsi de réaliser d'autres étapes de lithographie.

Ces déplacements peuvent aussi être problématiques car ils ne touchent pas uniquement les marques d'alignement secondaires ; ils touchent l'ensemble des deux surfaces collées. Si le but du collage était, par exemple, de mettre en vis-à-vis des motifs dans le but de réaliser une interconnexion verticale et que lesdits motifs de surfaces voient leur position relative trop perturbée par la distorsion, ils peuvent même ne plus se retrouver les uns en face des autres de part et d'autre de l'interface de collage et ainsi ne plus permettre l'interconnexion verticale recherchée.

Il est connu du document WO02054466 A1, dans une application spécifique liée à des orientations cristallines, un procédé rendant possible le contrôle de l'orientation cristalline entre deux monocristaux par l'élaboration, issue d'un même cristal, des deux surfaces que l'on souhaite coller. Cette invention permet d'aligner de façon macroscopique les axes cristallins de deux surfaces sans connaitre leur direction a priori, avec rotation des substrats. Cette invention s'occupe de l'ajustement global d'axes cristallins mais n'enseigne pas comment éviter le déplacement de marques secondaires éventuelles, et ne fournit pas de solution à des problèmes de placement de marques en vue d'un report d'une structure comprenant un substrat sur une autre. Elle n'est en outre pas compatible avec des substrats dont les couches à assembler ne sont pas monocristallines.

La présente invention permet de remédier en tout ou partie aux inconvénients techniques actuellement connus.

### RESUME DE L'INVENTION

Un aspect de modes de réalisation de l'invention concerne un procédé de réalisation d'un dispositif électronique comprenant en empilement au moins une première structure et une deuxième structure, les structures étant obtenues à partir d'un premier substrat et d'un deuxième substrat. De manière avantageuse, on effectue les étapes suivantes :
- formation d'au moins un motif de marque en creux sur une deuxième face, opposée à une première face, du premier substrat ;
- mise en place de la première face du premier substrat sur un premier support ;
- mise en place d'une première face du deuxième substrat sur un deuxième support ;
- assemblage des deux substrats par la deuxième face du premier substrat et une deuxième face, opposée à la première face, du deuxième substrat ;
- séparation du premier substrat en deux parties suivant une dimension en épaisseur du premier substrat de sorte à former une première partie du premier substrat restant en place sur le premier support, et une deuxième partie du premier substrat restant assemblée au deuxième substrat, la première partie du premier substrat comprenant une première marque formée par une première portion du motif de marque, la deuxième partie du premier substrat comprenant une deuxième marque formée par une deuxième portion du motif de marque ;
- réalisation d'au moins un composant électronique sur la première partie du premier substrat de sorte à former la première structure et d'au moins un composant électronique sur la deuxième partie du premier substrat de sorte à former la deuxième structure;
- assemblage de la première structure et de la deuxième structure, la première face du premier substrat étant en place sur le premier support et la première face du deuxième substrat étant en place sur le deuxième support, en rapprochant le premier support et le deuxième support tout en alignant la première marque et la deuxième marque.

Un autre aspect de modes de réalisation de l'invention s'adresse à un dispositif qui peut être obtenu par le procédé de l'invention.

Ainsi, les marques de la première structure et de la deuxième structure trouvent leur origine de fabrication dans un seul et même motif de marque si bien qu'elles sont en parfaite cohérence. En outre, le procédé suit un schéma de continuité de placement des structures dans des supports qui sont identiques à la fois pour l'opération d'assemblage des substrats de départ et pour l'opération d'assemblage des structures finales. On supprime de la sorte des risques de défaut d'alignement entre la première marque et la deuxième marque si bien que la solidarisation en empilement des deux structures est très précise dans sa localisation.

### INTRODUCTION DES DESSINS

Les dessins ci-joints sont donnés à titre d'exemples et ne sont pas limitatifs de l'invention. Ils représentent seulement un mode de réalisation de l'invention et permettront de la comprendre aisément.
- La figure 1 est une vue en coupe, suivant leur épaisseur, de deux structures amenées à former un dispositif microélectronique en empilement ;
- la figure 2 est une illustration d'un substrat de départ à la base d'une première structure;
- les figures 3 à 5 présentent des phases de traitement du premier substrat ;
- la figure 6 montre une phase de report d'un deuxième substrat sur le premier et la figure 7 présente leur configuration assemblée ;
- la figure 8 schématise une séparation en deux parties de l'assemblage de la figure 7 ;
- la figure 9 montre un traitement de surface postérieur à la phase de la figure 8 ;
- la figure 10 révèle un report de deux structures issues des substrats de départ et la figure 11 en donne une configuration assemblée de sorte à former un dispositif tridimensionnel.

Les épaisseurs des différentes couches représentées sur les figures ne sont pas forcément à l'échelle.

### DESCRIPTION DETAILLEE

D'autres buts et avantages apparaîtront au cours de la description qui suit qui présente des modes de réalisation de l'invention illustratifs mais non limitatifs.

Avant d'entrer dans le détail de ces modes de réalisation, on introduit brièvement ci-après des variantes préférées mais non limitatives utilisables seules ou selon toutes combinaisons entre elles et avec tout aspect objet des revendications, l'invention est telle que :
- l'assemblage des deux substrats comprend un rapprochement du premier support et du deuxième support, une mise en contact par une pression localisée de la deuxième surface du premier substrat et de la deuxième face du deuxième substrat de sorte à produire un collage direct, puis une désolidarisation de la première face du deuxième substrat relativement au deuxième support. La distance de rapprochement est identique pour les deux collages ;
- la formation d'au moins un motif de marque comprend : une gravure du motif de marque avec une hauteur prédéterminée suivant une dimension en épaisseur du premier substrat ; une formation d'une zone fragilisée, ladite zone fragilisée ayant un niveau de hauteur inférieur à la hauteur du motif de marque et la séparation du premier substrat en deux parties comprend un traitement configuré pour rompre la zone fragilisée ; cette zone fragilisée pouvant être réalisée avant ou après la gravure du motif.
- la formation d'une couche électriquement isolante sur la deuxième face du premier substrat avant la séparation du premier substrat en deux parties.

Les caractéristiques indiquées précédemment ne sont qu'optionnelles et pas obligatoirement exécutées dans cet ordre.

Le procédé de l'invention permet de fabriquer un dispositif dit électronique en ce sens qu'il comprend des parties électriques sur des structures qui peuvent, de préférence, comprendre un substrat par exemple en matériau semi-conducteur notamment à base de silicium. Le terme « substrat » s'entend de tout support semi-conducteur ou non, formant tout ou partie d'une structure. Il peut être mono ou multicouches. Typiquement, l'orientation du substrat définit, de part et d'autre de son épaisseur, deux faces. Dans le cadre de l'invention, une des faces d'un substrat donné peut coopérer avec un support, qui est de préférence un élément d'un outillage utilisé lors de la fabrication. L'autre face peut servir à réaliser des traitements tels que formation de couches au-dessus du substrat, formation de motifs dans le substrat et/ou des couches ajoutées, formation de composants électroniques simples (tels des lignes de distribution électrique) ou complexes (tels des transistors). L'expression composant électronique s'entend de tout organe pouvant avoir une application dans le domaine de l'électronique et de la microélectronique. Le terme composant électronique n'est pas limité à des composants ayant une fonction électrique. Il n'est pas exclu que la première face serve aussi à des traitements, par exemple dans une phase ultérieure à celles ici présentées. Des traitements peuvent aussi comprendre la formation de composants traversant l'épaisseur du substrat, tels des vias.

Le dispositif fabriqué selon l'invention est issu d'un empilement de structures à base de substrats telles que mentionnées au paragraphe précédent. Il peut s'agir d'un dispositif microélectronique. On entend par microélectronique notamment l'ensemble des techniques de microélectronique et de nanoélectronique. Les dispositifs que l'on peut former peuvent s'inscrire dans des systèmes du type systèmes micro-électro-mécaniques dits MEMS et/ou avec des fonctions optiques.

Les exemples présentés ci-après sont des empilements de deux structures mais ce nombre n'est pas limitatif et on peut répéter le procédé de l'invention pour plus de deux structures. Notamment, on peut assembler deux structures dans un premier temps, le dispositif obtenu formant ainsi une nouvelle structure globale qui peut alors être assemblée à une autre structure, de sorte à produire un dispositif à trois structures sous-jacentes.

Dans le cadre de la présente invention, des termes tels que « sur » ou « au-dessus » ne signifient pas obligatoirement « au contact de ». Ainsi, par exemple, la présence d'une couche sur une autre couche ne signifie pas obligatoirement qu'elles sont en contact. Cela ne signifie pas non plus que l'élément situé au-dessus de l'autre le recouvre totalement.

Le terme « épaisseur » s'entend, à moins qu'il en soit disposé autrement, d'une dimension suivant l'épaisseur du ou des substrats, par exemple perpendiculairement à un plan d'une surface du substrat. De même, le terme « largeur» s'entend, à moins qu'il en soit disposé autrement, d'une dimension perpendiculaire à l'épaisseur du substrat.

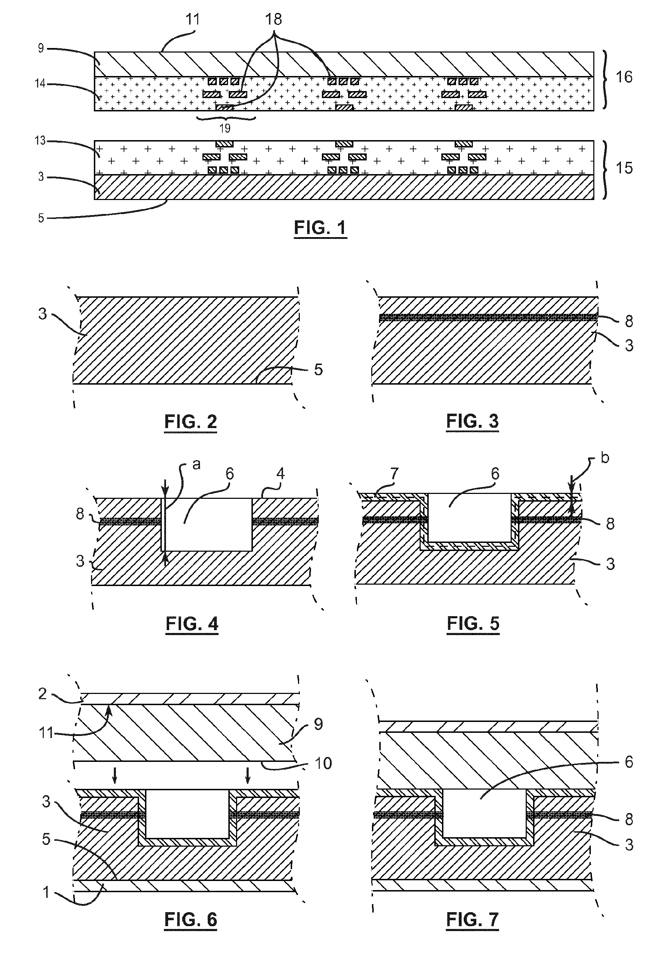

La figure 1 montre un exemple de configuration de deux structures à assembler. Une première structure 15 est ici en position inférieure et dispose d'une base issue d'un premier substrat 3 décrit plus loin surmonté par un ensemble fonctionnel 13 par exemple sous forme d'une pluralité de couches et/ou de composants 18 remplissant une fonction notamment électrique. Ces composants sont simplement schématisés par des motifs de matériaux différents du reste de la ou des couches qui les contiennent. Bien que cela ne soit pas illustré, le premier substrat 3 peut tout aussi bien comprendre des composants. Par exemple des vias (tels que des TSV, de l'anglais Through Silicon Via) peuvent y être formés. L'invention ne fait donc aucune hypothèse sur la configuration de la première structure 15.

D'autre part, la figure 1 montre une deuxième structure 16. Elle comporte une base dont une première face 11 est issue d'un deuxième substrat 9, et un ensemble fonctionnel 14. Les indications données précédemment pour ce type de composants 18 de structure, en référence à la première structure 15 sont valables pour la deuxième structure 16.

La deuxième structure 16 est orientée de sorte qu'une face à assembler soit en regard d'une face à lui associer de la première structure 15, ces faces étant avantageusement dirigées suivant des plans parallèles et perpendiculaires à l'épaisseur des substrats. Pour ce report, il est fait recours à des marques (non illustrées en figure 1), dites primaires, qui permettront d'aligner finement les deux structures 15, 16. On entend par un alignement, la mise en correspondance des deux structures suivant un plan perpendiculaire à leur épaisseur. Cela permet notamment des mises en contact d'organes électriques exposés à la surface des deux structures 15, 16. D'autres marques (non illustrées en figure 1), dites secondaires, peuvent aussi être employées, dans des zones 19 de réalisation de puces électroniques. En particulier, l'invention peut servir, sur la base de plaques, par exemple à partir silicium, à produire en groupe, une pluralité de puces d'un même type, puces qui sont réparties sur la surface des plaques et qui seront ensuite individualisées par des zones de découpe. On entend par puce tout système électronique dont les composants mentionnés précédemment. Les marques secondaires peuvent être reproduites dans chaque zone 19 pour servir de repères de proximité aux machines utilisées pour fabriquer les puces.

On indique ci-après une possibilité de fabrication de ces marques primaires et éventuellement secondaires, en référence aux figures 2 à 9. Ces dernières ne montrent que des vues partielles de substrats révélant la formation d'une marque. Cependant, des marques peuvent être produites, de préférence simultanément, en reproduisant le principe illustré à plusieurs endroits de la surface des substrats.

En référence à la figure 2, une étape de départ peut partir d'un premier substrat 3, par exemple de silicium, qui peut typiquement être une plaque circulaire (ou wafer en anglais) de 300 mm de diamètre ; sa résistivité est dans un exemple de 14 ohm/cm avec un dopage de type P.

On réalise (ensuite ou avant l'étape de formation de la couche isolante et/ou avant formation du motif de marque décrites ci-après) une zone fragilisée 8 au sein du premier substrat 3. On entend par zone fragilisée 8 une zone, située dans l'épaisseur du substrat 3 et de préférence non exposée à la surface de ce substrat 3, présentant une moindre résistance mécanique que les zones l'environnant. Cette fragilisation peut être obtenue par une implantation ionique d'atomes d'hydrogène avec une énergie de 55keV avec une dose de 6.10¹⁶ at/cm² pour placer le niveau du pic d'implantation de l'hydrogène à 150nm du fond du motif 6 des marques d'alignement. Le pic d'implantation se trouve ainsi avantageusement dans l'épaisseur du motif 6 qui est formé soit auparavant, soit ensuite comme en figure 4. En alternative à l'implantation ionique, la zone fragilisée 8 peut consister en une couche du substrat 3, aux propriétés mécaniques différentes des autres couches. Typiquement, la fabrication du substrat 3 peut comprendre la formation d'une couche poreuse suivie d'une croissance d'une couche non poreuse, de sorte que la couche poreuse interne au substrat soit le lieu d'un affaiblissement de ce dernier.

A la figure 4, on réalise le motif 6 sur la deuxième face 4 du substrat 3 qui va servir à la création de deux marques 6a, 6b chacune sur l'une des structures 15, 16, cette origine commune des marques assurant leur parfait alignement. On peut graver le motif avec par exemple des étapes de photolithographie. La profondeur (repérée « a » en figure 4) de gravure, dans le premier substrat 3 fait de silicium par exemple, de ces marques est optionnellement de 350nm. Un motif de section rectangulaire ou carrée peut convenir mais d'autre forme sont possibles.

Ensuite on réalise éventuellement une couche électriquement isolante 7 ayant une épaisseur « b », de préférence par une oxydation thermique qui peut se pratiquer à 950°C sous vapeur d'eau pour obtenir une couche d'oxyde de 100nm d'épaisseur ce qui consomme un peu le substrat 3 à partir de sa deuxième face 4, sur environ 50nm dans le cas du silicium. Le résultat est visible en figure 5. Cette couche 7 peut servir, alternativement ou cumulativement à la fonction d'isolation, servir à faciliter le collage direct.

Un deuxième substrat 9 est ensuite employé. Il peut aussi être fait de silicium, par exemple de 300mm de diamètre dont la résistivité est de 14ohm/cm avec un dopage de type P. Les deux substrats 3, 9 peuvent être de formats différents.

Les deux substrats subissent alors optionnellement un nettoyage, typiquement chimique avec un premier nettoyage utilisant une solution connue d'acide sulfurique, eau oxygénée dans les proportions 3:1, en utilisant une solution d'acide sulfurique à 96% en volume et une solution d'eau oxygénée à 30% en volume. Le temps de nettoyage est par exemple de 10mn à 180°C. Après un rinçage de 10mn dans l'eau dé ionisée, on opère un deuxième nettoyage, non limitativement à base d'ammoniaque, eau oxygénée et eau dé ionisée dans les proportions 1:1:5 en utilisant de l'ammoniaque et de l'eau oxygénée à 30% en volume pendant 10mn à 71°C. Les substrats 3, 9 sont ensuite rincés et séchés.

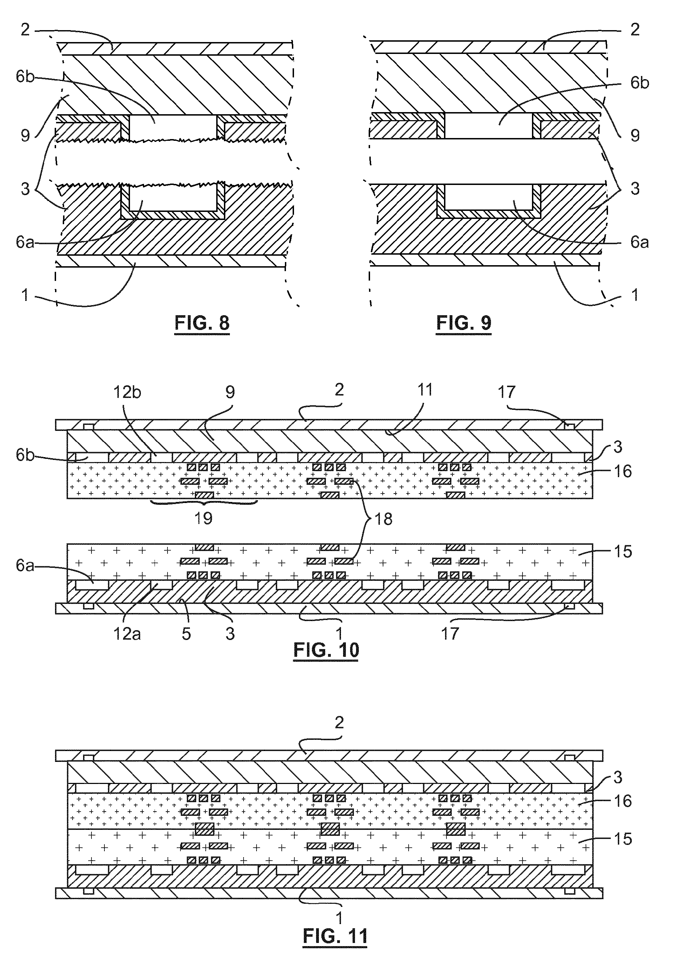

Le premier substrat 3 est placé alors sur un support 1 par sa première face 5 servant à le fixer en position durant des étapes de traitement. Le support 1 est notamment un mandrin généralement dénommé « chuck » en anglais. Le support 1 comprend dans l'exemple un plateau avec une surface, avantageusement plane, susceptible de recevoir une première face 5 du substrat 3. Il peut comprendre des éléments de maintien du substrat 3, en particulier par aspiration sur une couronne 17 visible en figure 10 débouchant au niveau de la première face 5 et raccordée à un circuit de dépression. Mais d'autre moyen de fixation peuvent exister.

Le deuxième substrat 9 est lui-aussi porté par un support 2 avec lequel il coopère par sa première face 11. On peut employer un support 2 de même technologie que le premier support 1.

Les deux substrats sont alors assemblés, de préférence par collage direct, technique d'assemblage par adhésion moléculaire. Les conditions peuvent être au moins l'une des suivantes :
- le support 1 pour premier substrat 3 et le support 2 pour le deuxième substrat 9 permettent le maintien de chaque substrat par du vide, avantageusement sur une même couronne de 0.1 mm située à 5 cm du bord des substrats 2, 9, ou avantageusement par un maintien avec une pluralité de petit trous de vide sur l'ensemble de la surface des chucks.
- on respecte un alignement des substrats 2, 9 par rapport à ces supports 1, 2 inférieur à +-50 µm dans les deux directions du plan de l'interface de collage ; des encoches ou méplats (généralement dénommées notches, et formées sur les bords des substrats, peuvent être employées à cette fin.
- les températures des substrats 2, 9 et des supports 1, 2 sont identiques avant de les mettre en contact et de préférence égale à 21 °C.
- l'atmosphère environnante est constituée de 78% d'azote, 21% d'oxygène et 1% de gaz rares à une pression de 1015 mbar à 21°C et avec 45% d'humidité relative.

Après alignement, les substrats 3, 9 sont rapprochés l'un de l'autre à une distance par exemple de 70 µm, comme en figure 6. Une déformation locale au centre du deuxième substrat 9 peut amorcer la mise en contact. Cette étape de mise en contact peut durer 20 secondes après que la force d'appui est atteinte (tel que 3500 mN). Ensuite le vide de la plaque du dessus est supprimé, permettant au collage de se terminer en libérant le deuxième substrat 9 du deuxième support 2. Après un délai, notamment de 30 secondes, le vide du premier substrat 3 est relâché et le collage est terminé. La configuration de la figure 7 est atteinte. L'énergie d'adhésion mise en oeuvre pour ce premier collage direct est de préférence de 110 mJ/m². La flèche de chaque substrat 3, 9 avant le collage est par exemple de 10 µm. Avantageusement, le collage s'opère à une température inférieure à 100°C, de préférence supérieur à 5°C et notamment ambiante, par exemple 21°C.

Ensuite, on effectue une séparation en deux parties de l'assemblage précédemment obtenu. A cet effet, par exemple, un recuit thermique (notamment à 500°C pendant deux heures) permet de provoquer une séparation au niveau de la zone fragilisée 8 (le pic d'implantation hydrogène en figure 7). Une partie du premier substrat 3 se trouve alors déportée avec le deuxième substrat 9.

Cette séparation coupe les motifs de marques d'alignement (primaires et/ou secondaires) en deux comme cela se produit pour le motif 6 en figure 8 où sont apparentes les marques primaires 6a, 6b qui dérivent de ce motif 6. Chaque partie possède ainsi des marques d'alignement primaires et/ou secondaires. Une source de désalignement des marques d'alignement secondaire est ainsi éliminée. Eventuellement, certaines marques secondaires peuvent faire office à la fois de marques secondaires et de marques primaires.

Après la séparation, une option est de polir la surface des deux parties obtenues par clivage de l'assemblage, par exemple avec un polissage mécanique ou mécano-chimique. Les surfaces exposées des deux parties séparées sont ainsi plus favorables à des traitements suivants, comme en figure 9.

Selon les applications, d'autres étapes technologiques sont en effet avantageusement réalisées sur chaque substrat. Cela peut comprendre des étapes de photolithographies, de gravures ioniques, de dépôts de couches minces et de polissages mécano-chimique par exemple. D'une manière générale, on forme au moins un composant électronique 18 sur chaque partie, ces composants 18 pouvant largement varier selon les applications.

On dispose alors de deux structures 15, 16, telles qu'en figure 1 où les composants 18 sont schématisés. Il est possible de les empiler de sorte à construire un dispositif tridimensionnel. Si l'épaisseur des structures 15, 16 le nécessite, on peut procéder à une ouverture de sorte à accéder aux marquages et à assurer la continuité du repérage au cours de la fabrication.

Préalablement, on s'assure de préférence que les conditions de flèche telles que définies précédemment sont toujours remplies. Sinon, certaines étapes technologiques comme le dépôt de couches minces de compensation de contrainte peut être nécessaire par exemple pour atteindre les spécifications de flèche d'origine.

Pour l'assemblage, le support 1 est réutilisé pour la structure 15 de sorte que c'est à nouveau la première face 5 qui coopère avec le même support 1. De même, le support 2 est réemployé pour la structure 16 si bien que la face 11 y est à nouveau en contact. Le maintien de chaque structure 15, 16 est de préférence réalisé dans les même conditions que lors des étapes de maintien des substrats en vue du premier assemblage. Cette étape est présentée en figure 10 où des marques primaires 6a, 6b, près de chaque bord des substrats de départ, sont visibles. Elles peuvent être organisées suivant un diamètre des premier et deuxième substrats. Aussi, des marques secondaires 12a, 12b sont formées, pour chaque zone de formation de puces.

Tout ou partie, mais avantageusement toutes les conditions du premier collage direct sont reprises pour le collage des deux structures 15, 16. Les conditions de températures, d'atmosphère, de préparation de l'accostage, et de collage directe sont donc de préférence toutes reproduites. Une tolérance maximale de 1% peut néanmoins par exemple être prise en ce qui concerne l'identité de distance des surfaces à coller avant mise en contact. Elle peut être au plus de 10% pour la force de collage ou encore de 1% pour les temps de relâchement des faces appliquées sur les supports 1, 2, ou de +/-0,1°C pour la température. L'énergie d'adhésion peut éventuellement varier de 20% maximum. Par ailleurs, les flèches ne devraient pas être modifiées de plus de +/- 10 µm pour une plaque de départ de 300 mm de diamètre et de +/- 7 µm pour une plaque de départ de 200 mm de diamètre. Cette tolérance éventuelle est de préférence la suivante pour l'atmosphère environnante des deux collages : pression à +-1%, type de gaz à +-1% en composition, température +-0.1°C, humidité +-5% d'écart entre les deux valeurs d'humidité relative des deux collages. Pour l'alignement global des deux structures lors du deuxième collage on restera de préférence inférieur à +-5µm, et plus spécifiquement inférieur à +-1µm ou 500 nm, ou 300 nm ou 100 nm.

On notera que l'alignement des structures 15, 16 par rapport aux supports 1, 2 est au départ et lors du deuxième collage de préférence inférieur à +-50µm dans les deux directions du plan de l'interface de collage.

Comme les conditions du deuxième collage sont très proches de celles du premier, voire identiques, cela permet de minimiser une autre source de désalignement des marques d'alignement, particulièrement les marques secondaires car on recolle les éléments dans les même conditions opérationnelles.

Ainsi, les deux collages sont des plus similaires, de préférence pour l'un au moins des paramètres suivants :
- l'alignement des plaques (substrats ou structures) par rapport aux supports ;
- la température des plaques et des supports ;
- l'atmosphère environnante des deux collages (pression, type de gaz, température, humidité) ;
- les étapes de déroulement des deux collages comprenant :
   - le rapprochement des plaques avant la mise en contact,
   - la façon dont les deux surfaces sont mises en contact
   - la façon dont les plaques sont détachées de leur support pendant les étapes de collage ;
- l'énergie d'adhésion mise en oeuvre pour les collages directs ;
- la flèche des plaques avant collage.

Lors de l'alignement avant collage, on peut exploiter les marques primaires 6a, 6b comme repères d'alignement. Des techniques optiques sont utilisables, par exemple dans l'infra-rouge, par transmission au travers des structures, en particulier si elles sont à base de silicium non fortement dopé, permettant une certaine transparence. D'autres techniques telles qu'avec des microscopes entre les structures sont utilisables.

Le résultat du collage, avant relâchement du maintien des supports 1, 2 est apparent en figure 11. Le dispositif est finalisé, à moins que d'autres étapes de fabrication ne soient à opérer ultérieurement. Pour le moins, l'empilement des deux structures 15, 16 a été effectuées dans les meilleures conditions d'alignement.

### REFERENCES

- 1.: Premier support
- 2.: Deuxième support
- 3.: Premier substrat
- 4.: Deuxième face
- 5.: Première face
- 6.: Motif
- 6a, 6b.: Marque primaire
- 7.: Couche isolante
- 8.: Zone fragilisée
- 9.: Deuxième substrat
- 10.: Deuxième face
- 11.: Première face
- 12a, 12b.: Marque secondaire
- 13.: Ensemble fonctionnel
- 14.: Ensemble fonctionnel
- 15.: Première structure
- 16.: Deuxième structure
- 17.: Couronne
- 18.: Composants
- 19.: Zone individuelle
- a.: Hauteur du motif
- b.: Hauteur de couche isolante

## Revendications

1. Procédé de réalisation d'un dispositif électronique comprenant en empilement au moins une première structure (15) et une deuxième structure (16), les structures étant obtenues à partir d'un premier substrat (3) et d'un deuxième substrat (9), **caractérisé par le fait qu'**on effectue les étapes suivantes :
- formation d'au moins un motif (6) de marque en creux sur une deuxième face (4), opposée à une première face (5), du premier substrat (3) ;
- mise en place de la première face (5) du premier substrat (3) sur un premier support (1) ;
- mise en place d'une première face (11) du deuxième substrat (9) sur un deuxième support (2) ;
- assemblage des deux substrats (3,9) par la deuxième face (4) du premier substrat (3) et une deuxième face (10), opposée à la première face (11), du deuxième substrat (9) ;
- séparation du premier substrat (3) en deux parties suivant une dimension en épaisseur du premier substrat (3) de sorte à former une première partie du premier substrat (3) restant en place sur le premier support (1), et une deuxième partie du premier substrat restant assemblée au deuxième substrat (9), la première partie du premier substrat (3) comprenant une première marque (6a) formée par une première portion du motif (6) de marque, la deuxième partie du premier substrat (3) comprenant une deuxième marque (6b) formée par une deuxième portion du motif (6) de marque ;
- réalisation d'au moins un composant électronique (18) sur la première partie du premier substrat (3) de sorte à former la première structure (15) et d'au moins un composant électronique (18) sur la deuxième partie du premier substrat (3) de sorte à former la deuxième structure (16) ;
- assemblage de la première structure (15) et de la deuxième structure (16), la première face (5) du premier substrat (3) étant en place sur le premier support (1) et la première face (11) du deuxième substrat (9) étant en place sur le deuxième support (2), en rapprochant le premier support (1) et le deuxième support (2) tout en alignant la première marque (6a) et la deuxième marque (6b).

2. Procédé selon la revendication 1, dans lequel la première face (5) du premier substrat (3) est désolidarisée du premier support (1) et la première face (11) du deuxième substrat (9) est désolidarisée du deuxième support (2) après l'assemblage des deux substrats (3,9), et puis dans lequel la première face (5) du premier substrat (3) est à nouveau solidarisée au premier support (1) et la première face (11) du deuxième substrat (9) est à nouveau solidarisée au deuxième support (2) après la réalisation d'au moins un composant électronique (18).

3. Procédé selon l'une des deux revendications précédente, dans lequel l'étape d'assemblage des deux substrats (3, 9) et l'étape d'assemblage de la première structure (15) et de la deuxième structure (16) sont opérées par collage direct.

4. Procédé selon la revendication précédente, dans lequel l'étape d'assemblage des deux substrats (3, 9) et l'étape d'assemblage de la première structure (15) et de la deuxième structure (13) sont opérées par collage direct avec une même énergie d'adhésion.

5. Procédé selon l'une des deux revendications précédentes, dans lequel l'étape d'assemblage des deux substrats (3, 9) et l'étape d'assemblage de la première structure (15) et de la deuxième structure (16) sont opérées par collage direct avec une même force de pression appliquée, pour les deux étapes au même endroit, par le premier support (3) et le deuxième support (2) aux premières faces (5, 11) des premier et deuxième substrats.

6. Procédé selon l'une des revendications précédentes, dans lequel l'étape d'assemblage des deux substrats (3, 9) et l'étape d'assemblage de la première structure (15) et de la deuxième structure (16) sont opérées avec une valeur identique pour au moins un des paramètres choisis parmi: la température des supports (1, 2) et des substrats ; la pression, la température, l'hygrométrie et la composition de l'atmosphère.

7. Procédé selon l'une des revendications précédentes, dans lequel l'assemblage des deux substrats (3, 9) comprend un rapprochement du premier support (1) et du deuxième support (2), une mise en contact de la deuxième surface (4) du premier substrat (3) et de la deuxième face (10) du deuxième substrat (9) de sorte à produire un collage direct, puis une désolidarisation de la première face (11) du deuxième substrat (9) relativement au deuxième support (2).

8. Procédé selon la revendication précédente, dans lequel la désolidarisation de la première face (11) du deuxième substrat (9) relativement au deuxième support (2) est suivie d'une désolidarisation de la première face (5) du premier substrat (3) relativement au premier support (1).

9. Procédé selon l'une des revendications précédentes, dans lequel la formation d'au moins un motif de marque (6) comprend :
- une gravure du motif (6) de marque avec une hauteur prédéterminée suivant une dimension en épaisseur du premier substrat (3);
- une formation d'une zone fragilisée(8), ladite zone fragilisée ayant un niveau de hauteur inférieur à la hauteur du motif de marque (6) ;
et dans lequel la séparation du premier substrat (3) en deux parties comprend un traitement configuré pour rompre la zone fragilisée (8).

10. Procédé selon la revendication précédente, dans lequel la formation d'une zone fragilisée (8) comprend une implantation ionique.

11. Procédé selon l'une des revendications précédentes, dans lequel on forme une pluralité de motifs (6) de marque en creux sur la deuxième face (4) du premier substrat (3) de sorte à former une pluralité de premières marques (6a, 12a) et une pluralité de deuxièmes marques (6b, 12b).

12. Procédé selon la revendication précédente, dans lequel on utilise un premier substrat (3) de section circulaire et dans lequel la pluralité de motifs (6) de marque comprend deux motifs de marque primaires (6a) situés à des bords diamétralement opposés du premier substrat (3).

13. Procédé selon l'une des deux revendications précédentes, dans lequel le premier substrat comprend une pluralité de zones individuelles (19) de réalisation d'une puce microélectronique et dans lequel la pluralité de motifs (6) de marque comprend au moins un motif de marque secondaire (12a) dans chaque zone individuelle (19).

14. Procédé selon l'une des revendications précédentes, dans lequel au moins l'une des faces situées en regard de la première structure (15) et de la deuxième structure (16) est formée par la surface d'une couche d'un matériau non monocristallin.
